# EUROPÄISCHE PATENTSCHRIFT

(11) **EP 2 867 629 B1**
(45) Veröffentlichungstag und Bekanntmachung des Hinweises auf die Patenterteilung: **26.02.2020**
(21) Anmeldenummer: 13726786.0
(22) Anmeldetag: 04.06.2013
(51) Int. Cl.: G01F 1/60

(54) **VERFAHREN ZUR STEUERUNG EINES SPULENSTROMS EINES MAGNETISCH-INDUKTIVEN DURCHFLUSSMESSGERÄTES**
METHOD OF CONTROLLING A SOLENOID CURRENT OF AN ELECTROMAGNETIC FLOWMETER
PROCÉDÉ DE CONTRÔLE DU COURANT PARCOURANT UN SOLÉNOIDE D'UN DÉBITMÈTRE ÉLECTROMAGNÉTIQUE

(30) Priorität: 28.06.2012 DE 102012105716
(43) Veröffentlichungstag der Anmeldung: 06.05.2015
(73) Patentinhaber: Endress+Hauser Flowtec AG, 4153 Reinach (BL) (CH)
(72) Erfinder: RÜFENACHT, Markus, CH-4106 Therwil (CH); SPAHLINGER, Andre, 79415 Bad Bellingen (DE); KÜNG, Thomas, CH-4052 Basel (CH)
(74) Vertreter: Andres, Angelika Maria
(86) Internationale Anmeldenummer: PCT/EP2013/061419
(87) Internationale Veröffentlichungsnummer: WO 2014/001026

(56) Entgegenhaltungen:
- DE-A1- 3 616 407
- DE-A1-102004 046 238

## Beschreibung

Die Erfindung betrifft ein Verfahren zur Steuerung des Spulenstroms eines magnetisch-induktiven Durchflussmessgerätes nach dem Oberbegriff des Anspruchs 1 und ein Magnetisch-induktives Durchflussmessgerät nach dem Oberbegriff des Anspruchs 10. Ein Spulenstrom fließt in einer eine Induktivität aufweisenden Spulenanordnung, die Teil eines Magnetsystems ist, welches Spulenkerne und/oder Polschuhe enthält. Dieser Spulenstrom ist getaktet, wobei der Spulenstrom in einer ersten Halbperiode einer Periodendauer positiv ist und einen konstanten ersten Strom-Endwert aufweist und in der zweiten Halbperiode der Periodendauer negativ ist und einen konstanten zweiten Strom-Endwert, der zum ersten Strom-Endwert betragsgleich ist, aufweist.

Die Spulenkerne und/oder Polschuhe des Magnetsystems bestehen meistens aus einem weich-magnetischen Material. Es sind aber auch schon Magnetsysteme mit ferromagnetischen Spulenkernen beschrieben worden.

Bei beiden Arten von Magnetsystemen werden im Magnetsystem aufgrund des Umschaltens und des Anstiegs des Spulenstroms Wirbelströme induziert, die verhindern, dass der Anstieg des Magnetfelds exakt dem Anstieg des Spulenstroms folgt, wie dies ohne Spulenkerne und/oder Polschuhe der Fall wäre. Vielmehr wird der Anstieg des Magnetfelds gegenüber dem des Spulenstroms verzögert und verflacht. Daher ist eine exakte Konstant-Regelung des Spulenstroms erforderlich.

Die EP 0 969 268 A1 offenbart ein Verfahren zur Steuerung des Spulenstroms wobei zunächst eine Überspannung in einem vorgegebenen Zeitintervall angelegt wird und nach diesem Zeitintervall eine Regelung erfolgt. Dieses Verfahren hat sich für den Regelfall an und für sich bewährt. Kommt es allerdings aufgrund von Schwankungen oder Störungen zu einer Verschiebung des Startpunktes, so würde beispielsweise eine höhere maximale Stromstärke in dem konstanten Zeitintervall erzeugt werden und könnte ggf. zu einer Überlastung führen.

Die DE 10 2004 046 238 A1 offenbart die Verwendung einer Gegenspannung zum schnelleren Erreichen des Stromendwerts; es wird eine iterative Anpassung der Zeitintervalle mit Über- und Gegenspannung vorgeschlagen.

Darüber hinaus sind auch Verfahren bekannt, welche eine Diagnosefunktion aufweisen, um eine maximale Stromstärke zu überprüfen. In diesen Verfahren dient die Stromstärke allerdings nicht als Regelgröße, sondern wird nur als Wert zur Überprüfung der Steuerung herangezogen.

Es ist daher Aufgabe der vorliegenden Erfindung ausgehend von der EP 0 969 268 A1 als nächstliegender Stand der Technik ein alternatives Verfahren zur Steuerung des Spulenstromes bereitzustellen.

Die Erfindung löst diese Aufgabe durch die Merkmale der Ansprüche 1 und 9.

Erfindungsgemäß ist ein Verfahren zur Steuerung des Spulenstroms eines magnetisch-induktiven Durchflussmessgerätes mit einem eine Überspannung U_{Ü} repräsentierenden ersten Wert und einem eine Haltespannung U_{H} repräsentierenden zweiten Wert, wobei der erste Wert größer ist als der zweite Wert, mit den folgenden Schritten

| | |
|---|---|
| A | Einstellen eines ersten Schaltpunktes I_{S} für die Stromstärke bis zu welcher eine Spule mit der Überspannung U_{Ü} versorgt werden soll; |
| B | Anlegen einer Überspannung U_{Ü}, bis die Stromstärke zum momentan eingestellten Schaltpunkt I_{S} der Stromstärke ansteigt; |
| C | Umschalten von der Überspannung U_{Ü} auf die Haltespannung U_{H}, um die Stromstärke auf einen konstanten Stromendwert I_{H} zu halten, dadurch gekennzeichnet, dass nach dem Umschalten, gemäß Schritt C, ein Auswerten der aktuellen Stromstärke I erfolgt und eine Einstellung des Schaltpunktes I_{S} anhand dieser aktuellen Stromstärke erfolgt. |

Durch das erfindungsgemäße Verfahren werden die im Stand der Technik beschriebenen Nachteile zuverlässig vermieden.

Vorteilhafte Ausgestaltungen der Erfindung sind Gegenstand der Unteransprüche. Nach dem Umschalten von der Überspannung auf die Haltespannung, welches vorzugsweise durch einen Komparator gesteuert wird, wächst die Stromstärke aufgrund der Eigeninduktivität der Spule noch geringfügig an. Nach dem geringen Anstieg der Stromstärke würde ein ebenfalls geringer Abfall der Stromstärke erfolgen, was den Komparator zu einem Rückumschalten auf eine Überspannung veranlassen würde. Um dieses Rückumschalten zu verhindern, sollte das Umschalten überwacht werden. Diese Überwachung und die Verhinderung des Überschaltungsbetriebes durch Rückumschalten des Komparators, welches sich aus dem speziellen Verfahren zur Steuerung des Spulenstromes ergibt, kann durch eine Flip-Flop-Schaltung vorteilhaft ermöglicht werden.

Besonders bevorzugt bietet sich die Verwendung des Verfahrens zur Steuerung des Spulenstromes in einem magnetisch-induktiven Durchflussmessgerät an, welches als Zweileiter-Feldgerät ausgebildet ist.

Historisch bedingt sind solche Zweileiter-Feldgeräten überwiegend so ausgelegt, dass eine auf einen zwischen 4 mA und 20 mA liegenden Wert eingestellte momentane Stromstärke des in dem als Stromschleife ausgebildeten einzigen Paar Leitung momentan fliessenden Versorgungsstroms gleichzeitig auch den momentan vom Feldgerät erzeugten Messwert bzw. den momentan an das Feldgerät gesendeten Einstellwert repräsentiert. Infolgedessen besteht ein besonderes Problem von solchen Zweileiter-Feldgeräten insoweit darin, dass die von der Feldgerät-Elektronik zumindest nominell umsetzbare oder umzusetzende elektrisch Leistung - im folgenden kurz "verfügbare Leistung" - während des Betriebes in praktisch unvorhersehbarer Weise über einen weiten Bereich schwanken kann. Dem Rechnung tragend sind moderne Zweileiter-Feldgeräte (2L-Feldgeräte), insb. moderne Zweileiter-Messgeräte (2L-Messgeräte) mit (4 mA bis 20 mA)-Stromschleife, daher üblicherweise so ausgelegt, dass ihre mittels eines in der Auswerte- und Betriebsschaltung vorgesehenen Mikrocomputers realisierte Geräte-Funktionalität änderbar ist, und insofern die zumeist ohnehin wenig Leistung umsetzende Betriebs- und Auswerteschaltung an die momentan verfügbare Leistung angepasst werden kann.

Nachfolgend wird eine bevorzugte Ausgestaltung der Erfindung anhand der beiliegenden Zeichnungen näher erläutert. Sie zeigen:
- Fig. 1: schematische Darstellung einer Schaltung, die nach dem erfindungsgemäßen Verfahren arbeitet ;und
- Fig. 2: Darstellung des Stromverlaufes des erfindungsgemäßen Verfahrens

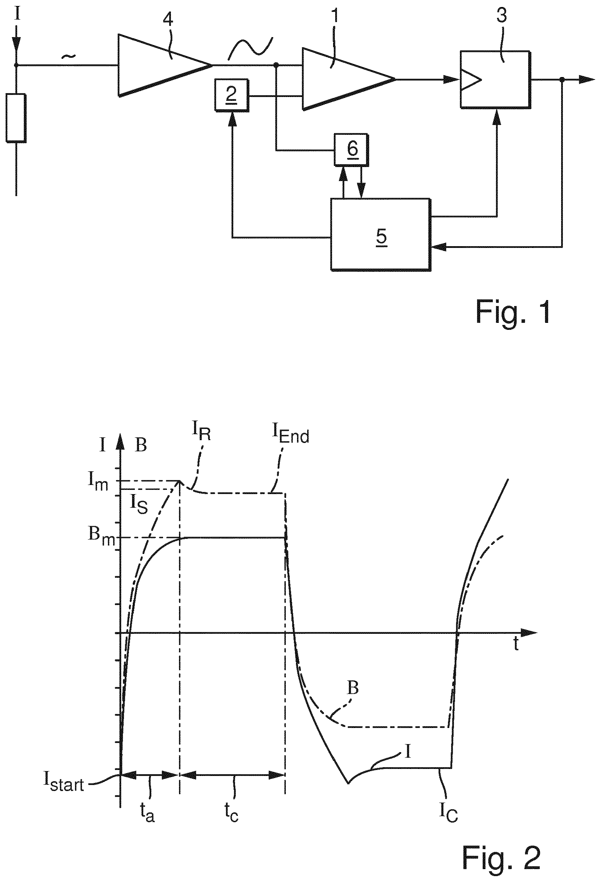

Das erfindungsgemäße Verfahren wird anhand des in Fig. 1 dargestellten Diagramms näher beschrieben.

Fig. 2 zeigt zunächst einen Stromverlauf zur Spulensteuerung, wie er auch durch das Verfahren der EP 0 969 268 A1, auf dessen Inhalt hiermit vollständig Bezug genommen wird, erreicht werden kann. Ein Spulenstrom fließt in einer eine Induktivität L aufweisende Spulenanordnung, die Teil eines Magnetsystems ist. Der Spulenstrom ist in der ersten Halbperiode einer Periodendauer positiv und danach durch ein Umschalten in einer zweiten Halbperiode der Periodendauer negativ. In dem in der EP 0 969 268, offenbarten Verfahren wird für eine Zeit tₐ eine Überspannung angelegt, um eine Stromstärke vom sogenannten negativen Feld auf das Niveau Iₘ anzuheben. Anschließend wird über einen Zeitraum t_{c} eine Haltespannung geliefert. Dabei steigt die Stromstärke während der Zeit tₐ auf den Wert Iₘ an. Der Spulenstrom I steigt während der Anstiegsdauer tₐ steil an

Nach dem aus der EP 0 969 268 A1 bekannten Verfahren war somit die Einstellung der Stromstärke an einen Startpunkt im negativen Feld gebunden. Es wurde ein Zeitintervall mit einer Überspannung hochgefahren und anschließend eine Zeitregelung zur Einstellung der Stromstärke vorgenommen.

Im Gegensatz dazu erfolgt bei dem erfindungsgemäßen Verfahren eine Versorgung der Spulenanordnung mit einer Überspannung Uü und anschließend mit einer Haltespannung U_{H}, wobei die Überspannung größer ist als die Haltespannung. Dabei erfolgt zunächst eine Einstellung eines Schaltpunktes I_{S} für die Stromstärke bis zu welcher eine Spule mit der Überspannung U_{Ü} versorgt werden soll.

Anschließend erfolgt ein Anlegen einer Überspannung U_{Ü}, bis die Stromstärke zum momentan eingestellten Sollwert I_{S} der Stromstärke ansteigt.

Schließlich erfolgt ein Umschalten von der Überspannung Uü auf die Haltespannung U_{H}, um die Stromstärke auf einen konstanten Stromendwert I_{H} zu halten.

Ein Verfahren, bei dem die Spulenanordnung mit einer Überspannung versorgt wird, bis die Stromstärke einen Schaltpunkt erreicht, der gleich dem Strom-Sollendwert ist, wonach auf eine Haltespannung umgeschaltet wird, ist aus der DE 36 16 407 A1 bekannt.

In Fig. 1 ist eine Schaltung zur Durchführung des Verfahrens gezeigt. In der Schaltung ist ein Verstärker 4 eingangsseitig mit einem Komparator 1 verbunden. Dieser ist ausgangsseitig mit einer Flip-Flop-Schaltung 3 verbunden. Weiterhin weist der Komparator eingangsseitig einen D/A-Wandler 2 auf. Dieser ist mit einer Auswerteeinheit 5 verbunden und wandelt digitale Signale der Auswerteeinheit 5 in analoge Signale um, welche zum Eingang des Komparators 1 geleitet werden. Von der Verbindung zwischen dem komparatoreingangsseitig angeordneten Verstärker 4 und dem Komparator 1 geht eine Verbindung zu einem A/D-Wandler 6 ab, welcher mit der Auswerteeinheit 5 verbunden ist. Die Flip-Flop-Schaltung 3 ist seitens des Preset mit der Auswerteeinheit verbunden und weist ausgangsseitig Verbindung zu einer nicht näher dargestellten Spannungsquelle auf. Vom Ausgang der Flip-Flop-Schaltung zweigt eine Verbindung zu einem Eingang der Auswerteeinheit 5 ab.

Die Funktionsweise der Schaltung wird nachfolgend anhand von stromäquivalenten Spannungen näher erläutert. Die Schaltung wird mit einem Eingangssignal einer Spannung mit geringer Amplitude versorgt, welches zunächst im Verstärker 4 verstärkt wird. Im Anschluss wird das verstärkte Eingangssignal an den Komparator 1 weitergeleitet. Ein Komparator ist bekannterweise ein Operationsverstärker ohne Gegenkopplung und ermöglicht den Vergleich von sehr kleinen Spannungsdifferenzen. Im konkreten Fall werden auf der Eingangsseite des Komparators 1 das verstärkte Eingangssignal E einerseits und ein Sollwert S für eine stromstärkenäquivalente Spannung andererseits gegenübergestellt. Dieser Sollwert S entspricht einem Schaltpunkt I_{S} für eine Stromstärke bis zu welcher eine Spule mit der Überspannung U_{Ü} versorgt werden soll. Der besagte Sollwert S wird durch die Auswerteeinheit 5 über den D/A-Wandler 2 an die Eingangsseite des Komparators 1 vorgegeben und ist regelbar.

Solange das Eingangssignal unter dem Sollwert liegt, also E<S, so erfolgt eine Versorgung der Spule durch die nachgeschaltete Spannungsquelle mit einer Überspannung U_{Ü}. Bei Erreichen des Sollwertes ändert sich das Ausgangssignal des Komparators derart, dass das neue Ausgangssignal ein Umschalten von der Überspannung U_{Ü} in eine Haltespannung U_{H} bewirkt, beispielsweise durch Vorzeichenwechsel oder durch Umschalten von 1 auf 0.

Durch das Umschalten kann es aufgrund der Eigeninduktivität der Spulenanordnung zu einem weiteren geringfügigen Anstieg der Stromstärke und der stromstärkenäquivalenten Spannung kommen, welche im Anschluss auf einen konstanten Stromendwert I_{End} für eine Haltespannung U_{H} abfällt. Dieser Abfall kann kurzzeitig dazu führen, dass das Eingangssignal E abermals kleiner dem Sollwert S ist, was zu einem Rückumschalten des Komparators 1 führt. Um einen daraus folgenden Überspannungsbetrieb zu verhindern ist der Komparator 1 ausgangsseitig mit einer Flip-Flop-Schaltung 3 gekoppelt.

Durch den Komparator wird somit, bezogen auf das Stromstärke-Zeit-Diagramm der Fig. 2, ausgehend von einem beliebigen Startpunkt I_{Start} der Stromzuwachs bis zu einemm eingestellten Schaltpunkt Iₛ nachverfolgt. Die Nachverfolgung und das Umschalten auf eine Haltespannung U_{H} übernimmt der Komparator 1 in Kombination mit einem D/A-Wandler 2, wie dies in Fig. 1 dargestellt ist. In der besonders bevorzugten Ausführungsvariante der Fig. 1 weist die Schaltung zusätzlich die Flip-Flop-Schaltung 3 auf, deren Funktion bereits erläutert wurde. Nach dem Umschalten auf die Haltespannung U_{H} stellt sich je nach der Selbstinduktion der Spule nach einiger Zeit ein konstanter Stromendwert I_{End} ein. Dieser Stromendwert I_{End} wird im vorliegenden Ausführungsbeispiel als Sollendwert voreingestellt bzw. festgelegt.

Gemäß Fig. 1 ist in der Schaltung der A/D-Wandler 6 vorgesehen, welcher eine stromäquivalente Spannung einer aktuellen Stromstärke I vor dem Eingang in den Komparator 1 in ein digitales Signal umwandelt und an die Auswerteeinheit 5 sendet. Das Eingangssignal E wird durch den A/D-Wandler 6 in ein digitales Signal umgewandelt, welches proportional ist zur aktuell anliegenden Stromstärke. Nach einem diskreten Zeitpunkt nach dem Umschalten auf Haltespannung U_{H}, beispielsweise nach 5 ms, wird von der Auswerteeinheit der aktuelle Wert des A/D-Wandlers abgefragt, welcher der aktuellen Stromstärke I_{R} zum Messzeitpunkt entspricht. Sofern der abgefragte Wert I_{R} kleiner ist als der Stromendwert I_{H} der Haltespannung U_{H}, so wird der Schaltpunkt I_{S} für die Stromstärke bis zu welcher eine Spule mit der Überspannung U_{Ü} versorgt werden soll bzw. die dazu stromäquivalente Spannung S am Eingang des Komparators, durch die Auswerteeinheit 5 und den D/A Wandler 2 auf einen höheren Wert eingestellt.

Die vorhergehende Erläuterung einer möglichen Einstellung des Schaltpunktes I_{S} für die Stromstärke bis zu welcher eine Spule mit der Überspannung U_{Ü} versorgt werden soll, ist dabei lediglich als bevorzugte Ausführungsvariante zu verstehen.

So kann in einer weiteren Ausführungsvariante beispielsweise als Sollendwert anstelle des Stromendwertes I_{End} eine Stromstärke gewählt werden, welche größer ist als der Stromendwertes I_{End}.

Erfindungsgemäß ist vorliegenden Verfahren die Stromstärke eine Regelgröße. Dabei wird beispielsweise bei Inbetriebnahme ein erster Schaltpunkt I_{S} für die Stromstärke von 22 mA vorgegeben. Anhand dieses ersten Startwertes erfolgt ein erstes Hochfahren der Stromstärke auf den besagten Schaltpunkt.

Im Anschluss an das Hochfahren und Umschalten, beispielsweise nach einer Zeit von 5 ms, erfolgt ein Vergleich der aktuellen Stromstärke I_{R} mit dem vorgegebenen Sollendwert. Liegt beispielsweise der Schaltpunkt I_{R} unter dem Sollendwert, so wird der regelbare Schaltpunkt I_{S} erhöht. Liegt beispielsweise der Schaltpunkt I_{R} über dem Sollendwert, so wird der einstellbare Schaltpunkt I_{S} erniedrigt. Somit erfolgt vor jedem Hochfahren bzw. Ansteigen ein erneutes Einstellen des Schaltpunktes I_{S}, mit deren stromäquivalenter Spannung S der Komparator 1 den bereits beschriebenen Vergleich mit dem Eingangssignal E durchführt.

Durch diese Schaltung ist ein Verfahren zur Spulenstromsteuerung eines magnetisch-induktiven Durchflussmessgerätes möglich.

Folglich ist - anders als bisher - das Umschalten zwischen der Überspannung und der Haltespannung direkt anhand eines einstellbaren Schaltpunktes I_{S} für die Stromstärke regelbar, während das Zeitintervall bis zur Einstellung dieser Schaltpunktes I_{S} variabel ist. Die Regelung des Umschaltintervalls durch die Vorgabe einer Stromstärke hat den Vorteil, dass dadurch auch Netzteile mit weniger konstanten Spannungen für Durchflussmessgeräte eingesetzt werden können. Da Spannungseinbrüche weniger Einfluss haben, können folglich auch kleiner-dimensionierte Netzteile verwendet werden, wodurch eine Miniaturisierung und eine Materialkostenersparnis erreicht wird. Eine Versorgung der Spulen mit getakteten Strom mit Pulspausen ist daher möglich, wobei bei Zweileiter-Feldgeräten insgesamt ein besseres Management der geringen zur Verfügung stehenden Stromstärke möglich ist. Außerdem wird eine Unabhängigkeit vom Startpunkt I_{Start} (bei t₀) erreicht.

Ein zusätzlicher Vorteil der vorliegenden Erfindung liegt in der schnelleren Anfahrzeit. Bislang musste zur Vermeidung einer Überlastung die Zeit tₐ langsam erhöht werden. So war es beispielsweise möglich, dass innerhalb des Zeitintervalls tₐ aufgrund äußerer Einflüsse die Stromstärke weit über den beabsichtigten Wert anstieg. Dies kann im vorliegenden Verfahren durch Vorgabe des Schaltpunktes für I_{S} vermieden werden.

Insgesamt ist das alternative Verfahren gegenüber dem bisherigen Verfahren robuster gegenüber Umwelteinflüssen. Es ist unabhängig vom Startpunkt und der Stabilität der angelegten Spannung.

## Patentansprüche

1. Verfahren zur Steuerung des Spulenstroms eines magnetisch-induktiven Durchflussmessgerätes mit einem eine Überspannung U_{Ü} repräsentierenden ersten Wert und einem eine Haltespannung U_{H} repräsentierenden zweiten Wert, wobei der erste Wert größer ist als der zweite Wert, mit den folgenden Schritten
A Einstellen eines ersten Schaltpunktes I_{S} für die Stromstärke bis zu welcher eine Spule mit der Überspannung U_{Ü} versorgt werden soll;
B Anlegen einer Überspannung U_{Ü}, bis die Stromstärke zum momentan eingestellten Schaltpunkt I_{S} der Stromstärke ansteigt;
C Umschalten von der Überspannung U_{Ü} auf die Haltespannung U_{H}, um die Stromstärke auf einen konstanten Stromendwert I_{H} zu halten,
**dadurch gekennzeichnet,**
**dass** nach dem Umschalten, gemäß Schritt C, ein Auswerten der aktuellen Stromstärke I erfolgt und eine Einstellung des Schaltpunktes I_{S} anhand dieser aktuellen Stromstärke erfolgt.

2. Verfahren nach Anspruch 1, **dadurch gekennzeichnet, dass** der Vergleich zwischen der aktuellen Stromstärke I_{R} und der momentan eingestellten Schaltpunkt I_{S} der Stromstärke anhand eines Komparators (1) erfolgt.

3. Verfahren nach einem der vorhergehenden Ansprüche, **dadurch gekennzeichnet, dass** der Vergleich eines Eingangssignals E einer stromäquivalenten Spannung auf einen momentan eingestellten Sollwert S für eine stromstärkenäquivalente Spannung S des Schaltpunktes I_{S}, vor dem Umschalten gemäß Schritt C, zeitunabhängig erfolgt.

4. Verfahren nach einem der vorhergehenden Ansprüche, **dadurch gekennzeichnet, dass** das Einstellen des ersten Schaltpunktes I_{S}, gemäß Schritt A, durch folgende Schritte erfolgt:
i) Ermittlung eines Wertes, welcher einer aktuellen Stromstärke I_{R} repräsentiert, nach dem Umschalten, gemäß Schritt C;
ii) Vergleich des der aktuellen Stromstärke I_{R} mit einem voreingestellten Sollendwert für den Stromendwert I_{End}, welcher sich bei anhaltender Haltespannung U_{H} einstellt; und
iii) Änderung des Schaltpunktes I_{S}, bei einer Abweichung des der aktuellen Stromstärke I_{R} vom Stromendwert I_{End}.

5. Verfahren nach einem der vorhergehenden Ansprüche, **dadurch gekennzeichnet, dass** der die Überspannung U_{Ü} repräsentierenden erste Wert mehr als doppelt so groß ist als der die Haltespannung U_{H} repräsentierenden zweite Wert.

6. Verfahren nach Anspruch 2 oder einem davon abhängigen Ansprüchen, **dadurch gekennzeichnet, dass** das Umschalten zwischen der Überspannung U_{Ü} auf die Haltespannung U_{H} durch den Komparator (1) veranlasst wird, wobei das Umschalten des Komparators (1) ausgewertet wird, um ein Rückumschalten auf die Überspannung U_{Ü} zu verhindern.

7. Verfahren nach Anspruch 6, **dadurch gekennzeichnet, dass** das Rückumschalten von der Haltespannung U_{H} auf die Überspannung U_{Ü} durch eine Flip-Flop Schaltung (3) verhindert wird.

8. Verwendung des Verfahrens zur Steuerung des Spulenstromes eines magnetisch-induktiven Durchflussmessgerätes in der Zweileitertechnologie.

9. Magnetisch-induktives Durchflussmessgerät, welches vorzugsweise als Zweileiter-Feldgerät ausgebildet ist, mit einer Spulenanordnung und einer Schaltung zur Steuerung eines Spulenstroms nach einem Verfahren der vorhergehenden Ansprüche,
welche Schaltung ausgelegt ist, um die Spulenanordnung mit einer Überspannung U_{Ü} und einer Haltespannung U_{H} zu versorgen,
wobei die Schaltung einen Komparator (1) aufweist, um einen Vergleich der aktuellen Stromstärke I_{R} mit einem momentan eingestellten Schaltpunkt Iₛ der Stromstärke durchzuführen,
wobei die Schaltung dazu eingerichtet ist, ein Umschalten von der Überspannung U_{Ü} zur Haltespannung U_{H} durchzuführen, sofern der eingestellte Schaltpunkt der Stromstärke I_{S} erreicht ist, und
wobei nach dem Umschalten ein Auswerten der aktuellen Stromstärke I erfolgt und eine Einstellung des Schaltpunktes I_{S} anhand dieser aktuellen Stromstärke erfolgt.

10. Magnetisch- induktives Durchflussmessgerät, gemäß Anspruch 9, **dadurch gekennzeichnet, dass** die Schaltung zudem eine Flip-Flop-Schaltung (3) zur Verhinderung des Rückumschaltens von der Haltespannung U_{H} auf die Überspannung U_{Ü} aufweist.

## Claims

1. Method to control the coil current of an electromagnetic flowmeter with a first value representing an overvoltage U_{Ü} and a second value representing a holding voltage U_{H}, wherein the first value is greater than the second value,
wherein said method comprises the following steps:
A Setting of a first switch point Is for the current intensity up to which a coil is to be supplied with the overvoltage U_{Ü};
B Application of an overvoltage U_{Ü} until the current intensity increases to the switch point I_{S} for the current intensity that is currently set;
C Switching from the overvoltage U_{Ü} to the holding voltage U_{H} in order to keep the current intensity at a constant current end value I_{H},
**characterized**
**in that** - following the switching as per Step C - the actual current intensity I is evaluated and the switch point I_{S} is set on the basis of this actual current intensity.

2. Method as claimed in Claim 1, **characterized in that** the comparison between the actual current intensity I_{R} and the switch point Is for the current intensity that is currently set is performed using a comparator (1).

3. Method as claimed in one of the previous claims, **characterized in that** the comparison of an input signal E of a voltage equivalent to the current with a target value S currently set for a voltage S of the switch point I_{S} that is equivalent to the current intensity takes place in a time-independent manner before the switching as per Step C.

4. Method as claimed in one of the previous claims, **characterized in that** the setting of the first switch point Is as per Step A is performed in the following steps:
i) Determination of a value, which represents an actual current intensity I_{R} after the switching as per Step C;
ii) Comparison of the actual current intensity I_{R} with a preset target end value for the current end value I_{End}, which is set in the event of a sustained holding voltage U_{H}; and
iii) Modification of the switch point Is in the event of a deviation of the actual current intensity I_{R} from the current end value I_{End}.

5. Method as claimed in one of the previous claims, **characterized in that** the first value representing the overvoltage Uu is more than twice the size of the second value representing the holding voltage U_{H}.

6. Method as claimed in Claim 2 or a dependent claim, **characterized in that** the switching between the overvoltage Uu to the holding voltage U_{H} is caused by the comparator (1), wherein the switching of the comparator (1) is evaluated to prevent a switch-back to the overvoltage U_{Ü}.

7. Method as claimed in Claim 6, **characterized in that** the switch-back from the holding voltage U_{H} to the overvoltage U_{Ü} is prevented by a flip-flop circuit (3).

8. Utilization of the method to control the coil current of an electromagnetic flowmeter in two-wire technology.

9. Electromagnetic flowmeter, which is preferably designed as a two-wire field device, with a coil arrangement and a circuit to control a coil current according to a method as claimed in the previous claims,
wherein said circuit is designed to supply the coil arrangement with an overvoltage Uu and a holding voltage U_{H},
wherein the circuit has a comparator (1) in order to compare the actual current intensity I_{R} with a switch point I_{S} for the current intensity that is currently set, wherein the circuit is configured to perform a switching from the overvoltage U_{Ü} to the holding voltage U_{H} if the set switch point for the current intensity I_{S} is reached, and
wherein, following the switching, the actual current intensity I is evaluated and the switch point I_{S} is set on the basis of this actual current intensity.

10. Electromagnetic flowmeter as claimed in Claim 9, **characterized in that** the circuit further comprises a flip-flop circuit (3) designed to prevent a switch-back from the holding voltage U_{H} to the overvoltage U_{Ü}.

## Revendications

1. Procédé destiné à la commande du courant de bobine d'un débitmètre magnéto-inductif avec une première valeur représentant une surtension U_{Ü} et une deuxième valeur représentant une tension de maintien U_{H}, la première valeur étant supérieure à la deuxième valeur,
avec les étapes de procédé suivantes :
A Réglage d'un premier point de commutation I_{S} pour l'intensité de courant jusqu'à laquelle une bobine doit être alimentée avec la surtension U_{Ü} ;
B Application d'une surtension U_{Ü} jusqu'à ce que l'intensité de courant augmente jusqu'au point de commutation I_{S} actuellement réglé de l'intensité de courant ;
C Commutation de la surtension U_{Ü} à la tension de maintien U_{H} afin de maintenir l'intensité de courant à une valeur finale de courant I_{H} constante,
**caractérisé**
**en ce que**, après la commutation selon l'étape C, a lieu une évaluation de l'intensité de courant I actuelle, suivie d'un réglage du point de commutation I_{S} sur la base de cette intensité de courant actuelle.

2. Procédé selon la revendication 1, **caractérisé en ce que** la comparaison entre l'intensité de courant I_{R} actuelle et le point de commutation I_{S} actuellement réglé de l'intensité de courant s'effectue au moyen d'un comparateur (1).

3. Procédé selon l'une des revendications précédentes, **caractérisé en ce qu'**une comparaison d'un signal d'entrée E d'une tension équivalente au courant par rapport à une valeur de consigne S actuellement réglée pour une tension S équivalente au courant du point de commutation I_{S} s'effectue avant la commutation selon l'étape C.

4. Procédé selon l'une des revendications précédentes, **caractérisé en ce que** le réglage du premier point de commutation I_{S} selon l'étape A est effectué au moyen des étapes suivantes :
i) Détermination d'une valeur, laquelle représente une intensité de courant I_{R} actuelle, après la commutation selon l'étape C ;
ii) Comparaison de l'intensité de courant I_{R} actuelle avec une valeur finale de consigne préréglée pour la valeur finale de courant I_{End}, qui s'établit dans le cas d'une tension de maintien U_{H} constante ; et
iii) Modification du point de commutation I_{S} en cas d'écart de l'intensité de courant I_{R} actuelle par rapport à la valeur finale de courant I_{End}.

5. Procédé selon l'une des revendications précédentes, **caractérisé en ce que** la première valeur représentant la surtension U_{Ü} est plus de deux fois plus grande que la deuxième valeur représentant la tension de maintien U_{H}.

6. Procédé selon la revendication 2 ou l'une des revendications en dépendant, **caractérisé en ce que** la commutation entre la surtension U_{Ü} et la tension de maintien U_{H} est déclenchée par le comparateur (1), la commutation du comparateur (1) étant évaluée en vue d'empêcher une recommutation à la surtension U_{Ü}.

7. Procédé selon la revendication 6, **caractérisé en ce que** la recommutation de la tension de maintien U_{H} à la surtension U_{Ü} est empêchée par un circuit flip-flop (3).

8. Utilisation du procédé destiné à la commande du courant de bobine d'un débitmètre magnéto-inductif en technologie 2 fils.

9. Débitmètre magnéto-inductif, lequel est conçu de préférence en tant qu'appareil de terrain 2 fils, avec un arrangement de bobines et un circuit destiné à la commande d'un courant de bobine d'après un procédé selon les revendications précédentes,
lequel circuit est conçu de telle sorte à alimenter l'arrangement de bobines avec une surtension U_{Ü} et une tension de maintien U_{H},
le circuit comportant un comparateur (1) en vue d'effectuer une comparaison de l'intensité de courant I_{R} actuelle avec un point de commutation I_{S} actuellement réglé de l'intensité de courant,
le circuit étant configuré de telle sorte à effectuer une commutation de la surtension U_{Ü} vers la tension de maintien U_{H}, dans la mesure où le point de commutation réglé de l'intensité de courant I_{S} est atteint, et
une évaluation de l'intensité de courant I actuelle étant effectuée après la commutation et un réglage du point de commutation I_{S} étant effectué sur la base de cette intensité de courant actuelle.

10. Débitmètre magnéto-inductif selon la revendication 9, **caractérisé en ce que** le circuit comprend en outre un circuit flip-flop (3) destiné à empêcher une recommutation de la tension de maintien U_{H} à la surtension U_{Ü}.
